# EUROPEAN PATENT SPECIFICATION

(11) **EP 0 829 960 B1**
(45) Date of publication and mention of the grant of the patent: **12.02.2003**
(21) Application number: 97307120.2
(22) Date of filing: 15.09.1997
(51) Int. Cl.: H03H 11/04

(54) **Improvements in or relating to electronic filters**
Verbesserungen in oder in bezug auf elektronische Filter
Améliorations pour ou relatives aux filtres électroniques

(30) Priority: 13.09.1996 US 26025 P
(43) Date of publication of application: 18.03.1998
(73) Proprietor: TEXAS INSTRUMENTS INC., Dallas, Texas 75243 (US)
(72) Inventor: Shanthi-Pavan,Yendluri 1312 S.W.Mudd Bldg, New York New York 10027 (US); Nagaraj,Krishnaswami, Somerville New Jersey 08876 (US); Gopinathan,Venugopal, New Jersey 07737 (US)
(74) Representative: Williams, Janice

(56) References cited:
- EP-A- 0 467 653
- US-A- 5 281 931
- US-A- 5 331 299
- US-A- 5 416 438

## Description

### BACKGROUND OF THE INVENTION

This application relates generally to electronic filters and,in a particular example to the tuning of high quality factor (Q) bandpass electrical circuit filters.

Filters of the type to which the present invention relates are devices that emphasize, de-emphasize, or control the frequency components of desired or undesired signals which might otherwise be present in electrical circuits. The filtering action may be achieved by electrical as well as other means, such as mechanical, piezoelectric, magnetostrictive or acoustic. Bandpass filters are filters which accept energy within a defined band or spectrum and significantly reject it outside that band or spectrum. Bandwidth (BW) is the frequency acceptance window or band between the 3-dB cut-off frequencies in a bandpass filter. In describing bandpass filters, quality factor (Q) is the ratio of the center frequency to the bandwidth. The center frequency (fc) is the geometric mean frequency between the 3-dB cut-off frequencies and may be approximated by the arithmetic mean when the Q factor is high (higher than about 10). See, generally, D. White, *A Handbook on Electrical Filters* (1963 Donald R.J. White, Germantown, Md.).

Filters used as bandpass filters for radio frequency devices such as cellular phones, for example, are typically formed on integrated circuits. Process variations in the integrated circuit manufacturing process yield differences in the center frequency of the bandpass filters that are formed. These filters must therefore be tuned in order for the center of the bandpass frequency to match the desired bandpass characteristic.

One known technique for tuning filters is the master/slave technique in which a master filter is tuned and the control parameters derived from tuning the master filter are used to drive the main filter, which is the slave filter. This system works well for low Q filters but does not work very well for high Q filters because of the narrowness of the high Q filters because of the narrowness of the high Q filter bandpass characteristic. Even a slight tracking error between the master and slave filters in a high Q filter system can place the bandpass characteristic outside the desirable range.

Another known technique is self-tuning. Here, the main filter itself is used for tuning. This requires the filter to be disconnected from its normal path. In many applications this can be done taking advantage of the idle times which are automatically available. In situations where there are no idle times, it may be necessary to use two such filters, with one being used while the other is being tuned.

The popular technique for implementing self-tuning for a high Q bandpass filter is to apply a sine wave at the desired center frequency and tune the filter until the phase difference between the output and input waves is 90°. A disadvantage of this technique is the requirement to have an accurate sine wave source at the operating frequency. This is not a problem at lower frequencies. However, at higher frequencies, such as 1GHz, even a small time delay in the circuit will result in a large phase error causing the filter to be mistuned. In addition, the circuits must have a source at the higher frequency and provision must be made to keep the higher frequency from being capacitively coupled to other portions of the circuit and causing interference therein.

Accordingly, there is a need for a low-cost and effective means for tuning the center frequency of high Q bandpass filters which is highly accurate and does not require a sine wave source at the center frequency.

EP-A1-0,467,653 discloses a cut-off frequency automatic adjusting filter. The filter includes a reference filter and a feedback circuit for the reference filter. The feedback circuit is formed by a subtracter, a full-wave rectifier, an integrator and an error amplifier.

### SUMMARY OF THE INVENTION

Respective aspects of the present invention are set forth in claims 1, 4, 7 and 11.

Embodiments of the present invention provide a method and apparatus for tuning electronic filters.

Further, embodiments of the present invention provide a method and apparatus for tuning the center frequency of a bandpass filter.

Embodiments of the present invention also provide a method and apparatus for tuning the center frequency of a bandpass filter formed on an integrated circuit.

One aspect of the present invention provides a method of detecting the center frequency of a bandpass filter. The filter is excited with a pulse causing the filter to ring at its tuned frequency. A predetermined number of cycles of the oscillating waveform generated by the ringing of the filter is counted. The time taken for the predetermined number of cycles to occur is compared with a known time reference.

Another aspect of the present invention is an apparatus for detecting the center frequency of a filter. A pulse generator excites the filter with a pulse causing the filter to ring at its tuned frequency. A counter counts a predetermined number of cycles of the oscillating waveform generated by the ringing of the filter. A comparator compares the time of the predetermined number of cycles with a known time reference.

A further aspect of the present invention is a method of tuning a filter. The filter is excited with a pulse causing the filter to ring at its tuned frequency. A predetermined number of cycles of the oscillating waveform generated by the ringing of the filter is counted. The time taken for the predetermined number of cycles to occur is compared with a known time reference to generate an output signal. The output signal is used to tune the filter.

Yet another aspect of the present invention is an apparatus for tuning a filter. A pulse generator excites the filter with a pulse for causing the filter to ring at its tuned frequency. A counter counts a predetermined number of cycles of the oscillating waveform generated by the ringing of the filter. A comparator compares the time taken for the predetermined number of cycles with a known time reference to generate an output signal. The output signal is used to tune the filter.

Yet another aspect of the present invention is an apparatus for tuning a filter. A pulse generator excites the filter with a pulse for causing the filter to ring at its tuned frequency. A counter counts a predetermined number of oscillatory waveforms generated by the ringing of the filter. A comparator compares the elapsed time of the predetermined number of oscillatory pulses with a reference signal to generate an output signal. An integrator integrates the output signal to generate a control signal to tune the filter.

### BRIEF DESCRIPTION OF THE DRAWINGS

The present invention will now be further described by way of example, with reference to the accompanying drawings in which:-
FIG. 1 is a block diagram of a filter tuning circuit embodiment of the present invention;
FIG. 2 is a schematic diagram of an implementation of the comparator and integrator of FIG. 1;
FIG. 3 is a pole-zero pattern to illustrate the second-order time domain transient response perturbation due to parasitic poles;
FIG. 4 is the step response of a second order bandpass filter having a Q of 10;
FIG. 5 shows the bandpass response of a filter with a Q of 10 having conjugate pair parasitic poles;
FIG. 6 is the pole-zero pattern for a higher order bandpass filter;
FIG. 7 is a block diagram of one implementation for generation of excitation and timing reference signals for the circuit of FIG. 1; and
FIG. 8 is a block diagram of a modified filter tuning circuit embodiment of the present invention.

Throughout the drawings, like numerals refer to like elements.

### DETAILED DESCRIPTION

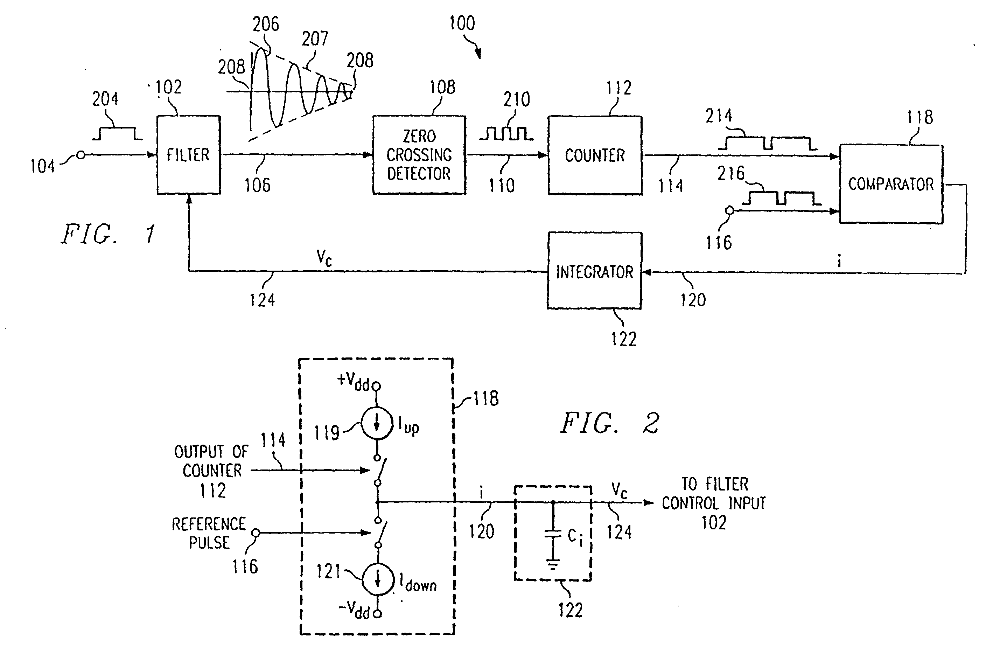

FIG. 1 is a block diagram showing an electronic filter tuning circuit 100 in accordance with an embodiment of the present invention. A filter 102, such as an integrated bandpass filter, is coupled to input terminal 104 for receiving an excitation input pulse which causes the filter to ring at its then set center frequency (fc). Filter 102 has a high Q factor of at least 10 and typically in the range of 10-20. The oscillating waveform that results from the ringing of filter 102 appears at the output of the filter on line 106 and is input to a zero crossing detector 108. Zero crossing detector 108 is used to detect the zero crossings in the oscillating waveform and may, for example, take the form of a Schmitt trigger. The output of zero crossing detector 108 is a series of digital pulses on line 110, with each pulse corresponding to a detected zero crossing in the oscillating output of filter 102 on line 106.

Line 110 couples the zero crossing pulse train to the input of a digital counter 112, which counts to a predetermined number n which may be an arbitrary number- chosen by the circuit designer. The output of counter 112 is fed on line 114 as a first input to a comparator 118. A second input to comparator 118 is an accurate known time reference applied at terminal 116 and which has a time period duration equal to the duration of n zero crossing pulses at a desired center frequency. The difference between the output of counter 112 and the reference generates a difference signal at the output 120 of comparator 118 that is fed to an integrator 122. Integrator 122 integrates this difference to generate a control signal on line 124 which adjusts the center frequency of filter 102 to align it with the desired center frequency.

The excitation pulse applied at terminal 114 can be of any frequency chosen by the designer, but needs to have a sufficiently sharp transient to cause the filter 102 to ring at its currently set center frequency. The frequency of the pulse is determined by the speed at which the filter needs to be tuned. The pulse may, for example, take the form of a square wave pulse 204 (FIG. 1) having an amplitude equal to the full scale filter operation amplitude (e.g., 1-volt amplitude pulse for a 1-volt full scale operating voltage filter) and a duration (e.g., 20-30 system clock pulse cycles) long enough to ensure that the filter receives an initial impulse sufficient to cause it to ring.

The output of the ringing filter 102 on line 106 is a damped oscillating waveform 206 that has an amplitude decay envelope (dashed lines 207) which decreases exponentially over time. The frequency of oscillation is the same as the then set center frequency (fc) of filter 102, and its period (T = 2π/fc) can be defined by the elapsed time between one zero crossing 208 and the next-but-are zero crossing 208. Each of the zero crossings 208 of the filter output 206 is detected by zero crossing detector 108 to generate a pulse on line 110. The frequency of the pulses in the pulse train 210 at 110 (viz., the frequency of zero crossings 208 detected by zero detector 108) will be twice the frequency (fc) of the ringing filter output 206. The period of the pulses in the pulse train 210 will be one-half the period of the ringing filter output 206. The pulse train 210 on line 110 is used to increment digital counter 112 to count to a predetermined number n of zero crossing pulses. This predetermined number n can be any number but is preferably moderately long so as to avoid the need for critical components.

For example, if a short duration count is chosen, then even a very small delay through the control circuit can yield a large error in the center frequency. However, if a larger number, for example n = 20 or 30, is chosen, then small delays will not have a great impact on the accuracy of the tuning of the center frequency of the filter 102. The utilization of the zero crossing detector 108 and counter 112 converts the task of tuning high frequency/short period filters into a lower frequency/longer period tuning problem, which is more easily solved. The output 214 of counter 112 on line 114 is a series of pulses which are 1/n times the frequency and n (for example, n = 20 or 30) times the period of the series of zero crossing detection output pulses at 110. This lower frequency/longer period signal 214, shown at the output of counter 112 in FIG. 1, is fed as a first input to comparator 118. Terminal 116 receives an accurate known timing reference signal 216 which is coupled into a second input of comparator 118. The timing signal 216 applied at 116 may be a series of pulses which correspond to what the signal 214 would look like were the center frequency (fc) of filter 102 properly tuned to the desired center frequency. The timing signal 216 may thus be a series of pulses having a frequency which is 2/n times the desired center frequency and a period which is n/2 times the period (elapsed time between one zero crossing and the next-but-one zero crossing) of the filter oscillating at the desired center frequency. Because the frequency of the reference signal applied at 116 is of the order of 10 or 15 times, for example, lower than the operating frequency of the filter, it is easily generated and less likely to be capacitively coupled into other circuits on the integrated circuit. In the example shown in FIG. 1, the pulses of output 214 of counter 112 have a period which is longer than the pulses of the reference signal 216 applied at 116, indicating that the actual frequency of filter 102 is lower than the desired frequency.

The output of comparator 118 on line 120 is a timing difference signal i which is developed based on the difference between the input signals 214 and 216 applied at 114 and 116, and which is then integrated by an integrator 122 to provide a control signal V_{c} on line 124 for tuning filter 102.

Each time the tuning operation is performed, the signal i output of comparator 118 is integrated by integrator 122 to generate a control signal on line 124 which tunes filter 102 to its center frequency, utilizing techniques well known in the art. The output on line 124 can be a DC voltage V_{c}, for example, and filter 102 can be tuned utilizing voltage control tuning techniques. The technique is advantageously applied iteratively until the filter is accurately tuned. The speed at which the filter is tuned to its desired center frequency is determined, in part, by the frequency of the pulses in the excitation signal 204 applied to terminal 104. A higher rate of pulses will allow more iterations in a given time period and thus enable faster control. The filters need to be periodically tuned, and such tuning may be necessary every few milliseconds, depending upon the operation. In a cellular telephone, for example, the tuning of the filter can be accomplished during the lulls in the conversation, making the tuning procedure totally transparent to the user. In those situations in which there are no lulls in the transmission and interruptions in the transmission are not acceptable, it may be necessary to have two such filters, one in use while the other is being tuned.

Comparator 118 and integrator 122 may be implemented, for example, as shown schematically in FIG. 2. Counter output line 114 is connected to control operation of a positive current source 119, connected between a positive voltage source +V_{dd} and line 120. Reference signal input terminal 116 is connected to control operation of an equal, but opposite, negative current source 121, connected between a line 120 and a negative voltage source -V_{dd}. An integrating capacitor Cᵢ has one terminal connected to lines 120 and 124, and the other terminal connected to ground. When the counter output signal 214 at line 114 is high (or, in an alternative implementation, low) and the reference signal 216 at terminal 116 is low (or, in the alternative, high), current Iᵤₚ is flowed from positive voltage source +V_{dd} into line 120 to charge capacitor Cᵢ in a positive direction. On the other hand, when the signal 214 on line 114 is low (or, alternatively, high) and the signal 216 at terminal 116 is high (or, alternatively, low), current I_{down} is flowed out of line 120 to negative voltage source -V_{dd} to charge capacitor Cᵢ in the opposite or negative direction. However, when the signals 214, 216 at line 114 and terminal 116 are either both high or both low, no net current is flowed either into or out of line 120. Thus, when the actual center frequency of filter 102 is lower than the desired center frequency (case shown in FIG. 1), the period of pulses on line 114 will be longer than the period of the pulses at terminal 116, and instances of Iᵤₚ application will exceed instances of I_{down} application. This will lead to development of a net positive charge on capacitor Cᵢ and generation of a positive control voltage V_{c} on line 124. On the other hand, when the actual center frequency of filter 102 is higher than the desired frequency, the pulses on line 114 will have a shorter period than those at terminal 116, and instances of I_{down} application will dominate, leading to a net negative charge on capacitor Cᵢ and generation of a negative control voltage V_{c}. The control voltage V_{c} will then be used in known ways to increase or decrease the frequency of filter 102, until the period of the pulses on line 114 is the same as the period of the pulses at terminal 116 and the control voltage V_{c} is brought to a constant value.

The frequency of zero crossings in the oscillating waveform 206 of the ringing filter 102 is an accurate representation of the current setting of the center frequency of filter 102. This can be demonstrated by considering a second-order bandpass filter with the transfer function:

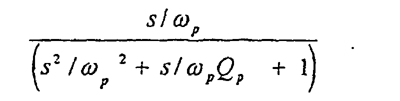

The step response of this system is: 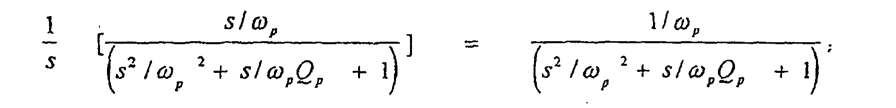 where s is the well-known complex frequency, ω_{*p*} is the center frequency of the filter transmission, and Qₚ is the quality factor. The time response of this function for a step input is of the form$\text{y} \text{(} \text{t} \text{) =} \text{A} {\text{exp (-σ}}_{\text{1}} \text{t} {\text{) sin ω}}_{\text{1}} \text{t} \text{;}$ where A is a constant, σ₁ = *ω*_{*p*}/2*Q*_{*p*}, and ω₁ is the frequency of the zero crossings given by${\text{ω}}_{\text{1}} {\text{= ω}}_{\text{p}} \sqrt{\text{(1 - 1/4} {\text{Q}}_{\text{p}} {}^{\text{2}} \text{)}} \text{.}$ The difference between ω₁ and ω_{*p*} is approximately equal to *ω*_{*p*}/8*Q*_{*p*}² for high values of Qₚ. This difference is very small, even for modest values of Qₚ. Thus, for high Q factor filters, ringing the filter 102 and counting the zero crossings 208 in the resulting signal 206 is an excellent method for determining the actual center frequency setting of the filter 102.

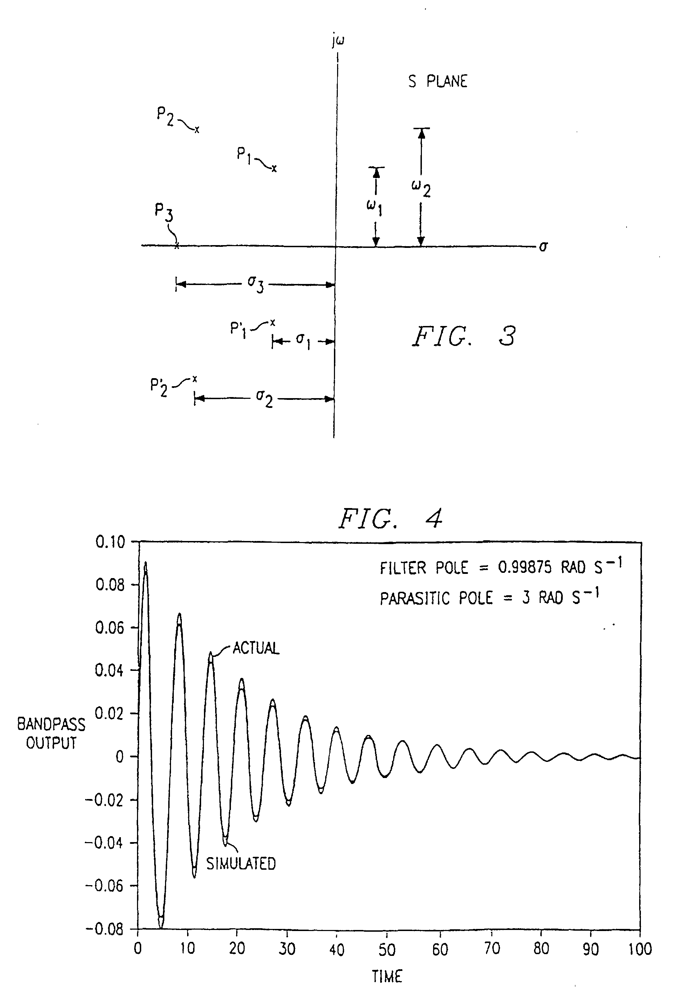

The effect of parasitic poles on the transient response and the magnitude response of the filter is minimal. Assuming that parasitic poles are of higher frequency than the filter passband, a possible scenario is that given in the pole-zero pattern representation shown in FIG. 3. The usual poles are indicated at P₁ and P₁'. The parasitic poles are indicated at P₂, P₂' and P₃. The time response for a step input function with the indicated parasitic poles can be shown to be:${\text{y(t) = exp ( - σ}}_{\text{1}} {\text{t ){ A sin ( w}}_{\text{1}} {\text{t ) +B exp ( - (σ}}_{\text{3}} {\text{- σ}}_{\text{1}} \text{) t)} {\text{+ C exp ( - (σ}}_{\text{2}} {\text{- σ}}_{\text{1}} {\text{) t) sin ( ω}}_{\text{2}} {\text{t + f}}_{\text{2}} \text{)};}$ where, by definition | σ₁| << |σ₂|, |σ₃|. The complex frequencies corresponding to the parasitic poles die down very fast. Therefore, these poles have a negligible impact on this technique.

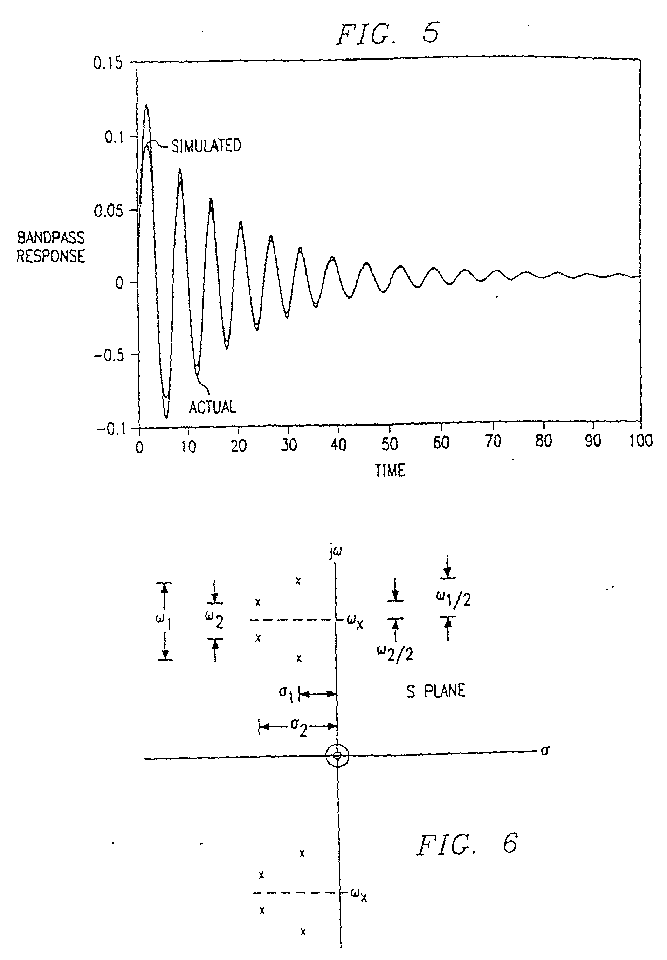

The zero crossing measurements thus give an excellent measure of the maximum filter transmission for high Q filters. Simulations have verified such an approach to be an order of magnitude more accurate than using a conventional phase measurement scheme. The comparisons of actual versus the simulated responses are given in FIGS. 4 and 5.

The present invention is also applicable to higher order filters. All higher order bandpass filters try to approximate an ideal transfer function with an impulse response given by: 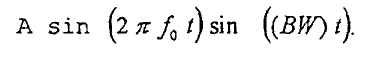 The ideal filter is, of course, not realizable, and has a delay of infinity. All filter approximation techniques aim to minimize the error between a rational function of s and the ideal filter characteristic. It is, therefore, reasonable to expect that the transient responses of all such filters will also closely approximate the ideal impulse response. A "physical" explanation may be evident from consideration, for example, of a Chebyshev bandpass filter. This is obtained by using the L·P to B·P transformation on the L·P prototype. For very narrow band filters, the pole locations are symmetric about the line s=jωₓ, where ωₓ is the arithmetic average frequency of the imaginary parts of the poles (see FIG. 6). The transient response is of the form: 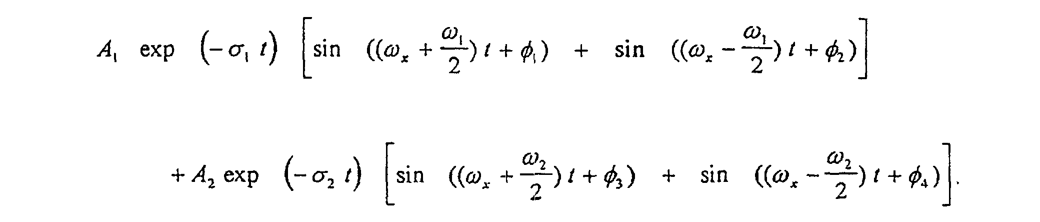 Now, 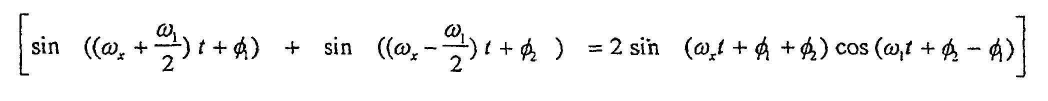 where the sine term is a sine wave corresponding to the center frequency of the bandpass filter and the cosine term is a beat frequency (a low frequency envelope). Therefore, the frequency of the zero crossings corresponds to the center frequency of the bandpass filter, the difference being of the order of about 0.1%.

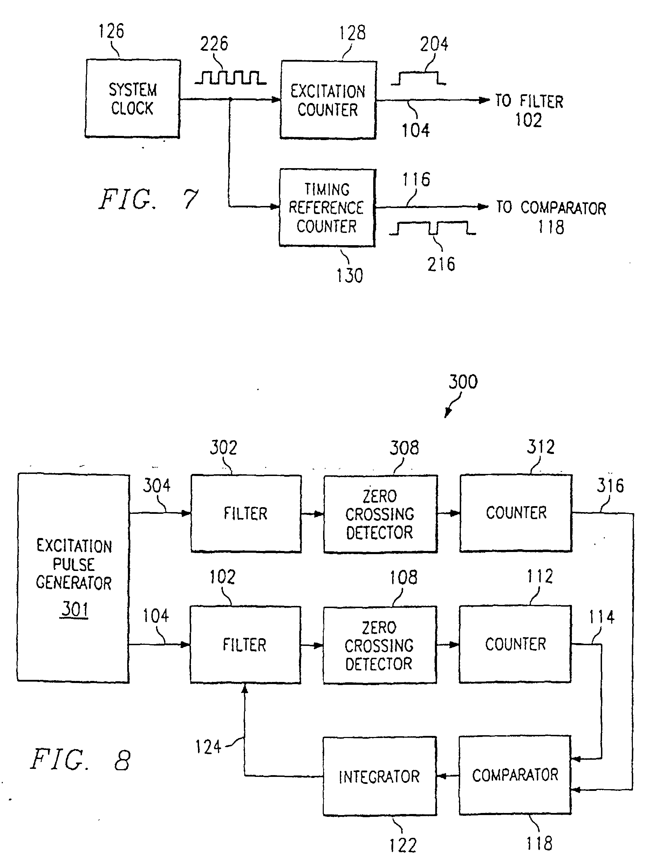

FIG. 7 shows one possible implementation for generation of the excitation signal 204 and timing reference signal 216 for circuit 100 of FIG. 1. A system clock 126 generates a series of clock pulses 226 which are input to an excitation counter 128. Counter 128 is hard wired or programmed to count to a number m of clock pulses to produce an excitation signal 204 having a pulse width duration of m system clock pulse cycles. Similarly, clock pulses 226 are also input to a timing reference counter 130. Counter 130 is hard wired or programmed to count to a number k of clock pulses to produce a timing reference signal 216 having a pulse width duration of k system clock pulses. Selection of the count n of zero crossing counter 112 and count k of timing reference counter 130 is made, so that the pulse duration of signal 216 will correspond to the pulse duration of signal 214 for filter 102 tuned to the desired central frequency. Any error in matching is minimized because the periods of the matched signals 214, 216 are made much longer than the period of the signal 206.

FIG. 8 shows a modified embodiment 300 of the tuning circuit 100 of FIG. 1. Here, signal 204 (see FIG. 1) is generated by an excitation pulse generator 301 (which may take the form of system clock 126 and counter 128 of FIG. 7, if desired) which is included in a single integrated circuit along with the filter 102, zero crossing detector 108, counter 112, comparator 118 and integrator 122 elements of FIG. 1. The timing reference signal 216 is now, however, generated by filter 302, zero crossing detector 308 and counter 312 elements which are configured the same as the corresponding filter 102, zero crossing detector 108 and counter 112 elements. This, therefore, presents a relationship wherein a first filter 102 can be tuned to a second filter 302, or vice versa. The same signal form 204 (FIG. 1) used to excite filter 102 via input 104 is also fed to filter 302 via a line 304. Zero crossing detector 308 then produces pulses like those of signal 210 shown in FIG. 1 from the damped oscillating waveform (similar to 206 in FIG. 1) output of filter 302. Counter 312 counts a number n of the zero detection pulses to produce an output (similar to 214 in FIG. 1) with a pulse frequency which is a 2/n multiple of the set central frequency for filter 302. The output (similar to 214 in FIG. 1) of counter 312 is then compared, as previously described for the timing reference signal input at 116, with the corresponding signal 214 from counter 112, to provide a tuning control signal to filter 102 to tune filter 102 to filter 302.

Those skilled in the art to which the invention relates will appreciate that the foregoing are merely, illustrative examples of embodiments and applications of the invention, and that changes and modifications can be made to the above, without departing from the scope of the invention.

## Claims

1. A method for detecting the filter pole frequency of a filter, comprising:
exciting said filter (102) with a pulse for causing said filter (102) to ring to generate an oscillating waveform;
counting a predetermined number of oscillations in said oscillating waveform generated by said ringing of said filter (102);
comparing the elapsed period for said predetermined number of oscillations with a known reference period to generate a difference signal corresponding to the difference between said elapsed period and said known reference period; and integrating said difference signal to generate a control signal (Vc).

2. The method of Claim 1, wherein said counting step comprises counting the number of zero crossings (208) in said oscillating waveform (206) and counts for said predetermined number.

3. The method of Claim 1, wherein said counting step comprises the steps of converting said oscillating waveform into a series of pulses (210) and digitally counting said series of pulses.

4. Apparatus for detecting the filter pole frequency of a filter comprising:
a pulse generator for exciting said filter (102) with a pulse for causing said filter (102) to ring to generate an oscillating waveform (206);
a counter (112) coupled to said filter (102), for counting a predetermined number of oscillations in said oscillating waveform (206) generated by said ringing of said filter (102);
a comparator (118), coupled to said counter (112), for comparing the elapsed period of said predetermined number of oscillations with a known reference period to generate a difference signal; and
an integrator (122) coupled to said comparator (118) for integrating said difference signal to generate a control signal (Vc).

5. The apparatus of Claim 4, wherein said counter (112) is a digital counter.

6. The apparatus of Claim 4 or 5, further comprising a zero crossing detector (108) for converting said oscillating waveform into a series of pulses.

7. A method of tuning a bandpass filter, comprising the method of claim 1, wherein
said exciting said filter (102) with a pulse causes said filter (102) to ring at its set center frequency to generate said oscillating waveform (206); and comprising the step of
tuning said filter (102) with said control signal (Vc).

8. The method of Claim 7, wherein said counting step comprises counting the number of zero crossings (208) in said oscillating waveform (206) and counts for said predetermined number.

9. The method of Claim 7, wherein said counting step comprises the steps of converting said oscillating waveform into a series of pulses (210); and digitally counting said series of pulses.

10. The method of Claim 7, 8 or 9 wherein, in said comparing step, said known reference period corresponds to the elapse period for the same number of oscillations as said predetermined number of oscillations to elapse for a corresponding oscillating waveform generated by a filter (102) ringing at a center frequency equal to a desired center frequency.

11. Apparatus for tuning a bandpass filter, comprising the apparatus of claim 4, wherein
said pulse generator for exciting said filter (102) with a pulse causes said filter (102) to ring at its set central frequency to generate said oscillating waveform (206); and said
control signal (Vc) tunes said filter (102).

12. The apparatus of Claim 11, wherein said counter (112) is a digital counter.

13. The apparatus of Claim 11 or Claim 12, further comprising a zero crossing detector (108) for converting said oscillating waveform into a series of pulses.

14. The apparatus of Claim 11, 12 or 13, further comprising a reference signal generator (301) for generating said known reference period corresponding to the elapsed period for the same number of oscillations as said predetermined number of oscillations to elapse for a corresponding oscillating waveform generated by a second filter (302) identical to said first filter (102) ringing at a center frequency equal to a desired center frequency to which said first filter (102) is to be tuned.

## Patentansprüche

1. Verfahren zum Erfassen der Filterpolfrequenz eines Filters, bei dem:
das Filter (102) mit einem Impuls erregt wird, um das Filter (102) zum abklingenden Schwingen zu veranlassen, um eine oszillierende Signalform zu erzeugen;
eine vorgegebene Anzahl von Oszillationen in der durch das abklingende Schwingen des Filters (102) erzeugten oszillierenden Signalform gezählt wird;
die verstrichene Zeitspanne für die vorgegebene Anzahl von Oszillationen mit einer bekannten Referenzzeitspanne verglichen wird, um ein der Differenz zwischen der verstrichenen Zeitspanne und der bekannten Referenzzeitspanne entsprechendes Differenzsignal zu erzeugen; und das Differenzsignal integriert wird, um ein Steuersignal (Vc) zu erzeugen.

2. Verfahren nach Anspruch 1, bei dem in dem Zählschritt die Anzahl der Nulldurchgänge (208) in der oszillierenden Signalform (208) und der Zählungen der vorgegebenen Anzahl gezählt werden.

3. Verfahren nach Anspruch 1, bei dem der Zählschritt die Schritte umfaßt, bei denen die oszillierende Signalform in eine Reihe von Impulsen (210) umgesetzt wird und die Reihe von Impulsen digital gezählt wird.

4. Vorrichtung für die Erfassung der Filterpolfrequenz eines Filters, die umfaßt:
einen Impulsgenerator, der das Filter (102) mit einem Impuls erregt, um das Filter (102) zum abklingenden Schwingen zu veranlassen, um eine oszillierende Signalform (206) zu erzeugen;
einen Zähler (112), der mit dem Filter (102) gekoppelt ist und eine vorgegebene Anzahl von Oszillationen in der durch das abklingende Schwingen des Filters (102) erzeugten oszillierenden Signalform (206) zählt;
einen Komparator (118), der mit dem Zähler (112) gekoppelt ist und die verstrichene Zeitspanne der vorgegebenen Anzahl von Oszillationen mit einer bekannten Referenzzeitspanne vergleicht, um ein Differenzsignal zu erzeugen; und
einen Integrator (122), der mit dem Komparator (118) gekoppelt ist und das Differenzsignal integriert, um ein Steuersignal (Vc) zu erzeugen.

5. Vorrichtung nach Anspruch 4, bei der der Zähler (112) ein digitaler Zähler ist.

6. Vorrichtung nach Anspruch 4 oder 5, die ferner einen Nulldurchgangsdetektor (108) umfaßt, der die oszillierende Signalform in eine Reihe von Impulsen umsetzt.

7. Verfahren zum Abstimmen eines Bandpaßfilters, das das Verfahren nach Anspruch 1 enthält und bei dem
die Erregung des Filters (102) mit einem Impuls dieses Filter (102) zu einem abklingenden Schwingen bei seiner festgesetzten Mittenfrequenz veranlaßt, um die oszillierende Signalform (206) zu erzeugen;
und das den Schritt umfaßt, bei dem
das Filter (102) mit dem Steuersignal (Vc) abgestimmt wird.

8. Verfahren nach Anspruch 7, bei dem bei dem Zählschritt die Anzahl der Nulldurchgänge (208) in der oszillierenden Signalform (206) und die Zählungen der vorgegebenen Anzahl gezählt werden.

9. Verfahren nach Anspruch 7, bei dem der Zählschritt die Schritte umfaßt, bei denen die oszillierende Signalform in eine Reihe von Impulsen (210) umgesetzt wird; und die Reihe von Impulsen digital gezählt wird.

10. Verfahren nach Anspruch 7, 8 oder 9, bei dem in dem Vergleichsschritt die bekannte Referenzperiode der Verstreichperiode entspricht, die die gleiche Anzahl von Oszillationen wie die vorgegebene Anzahl von Oszillationen für eine entsprechende oszillierende Signalform, die durch ein Filter (102) erzeugt wird, das bei einer Mittenfrequenz, die gleich einer erwünschten Mittenfrequenz ist, abklingend schwingt, zum Verstreichen benötigen.

11. Vorrichtung zum Abstimmen eines Bandpaßfilters, die die Vorrichtung nach Anspruch 4 enthält, bei der
der Impulsgenerator zum Erregen des Filters (102) mit einem Impuls das Filter (102) zum abklingenden Schwingen bei seiner festgesetzten Mittenfrequenz veranlaßt, um die oszillierende Signalform (206) zu erzeugen; und
das Steuersignal (Vc) das Filter (102) abstimmt.

12. Vorrichtung nach Anspruch 11, bei der der Zähler (112) ein digitaler Zähler ist.

13. Vorrichtung nach Anspruch 11 oder Anspruch 12, die ferner einen Nulldurchgangsdetektor (108) umfaßt, der die oszillierende Signalform in eine Reihe von Impulsen umsetzt.

14. Vorrichtung nach Anspruch 11, 12 oder 13, die ferner einen Referenzsignalgenerator (301) umfaßt, der die bekannte Referenzperiode erzeugt, die der Verstreichperiode entspricht, die die gleiche Anzahl von Oszillationen wie die vorgegebene Anzahl von Oszillationen für eine entsprechende oszillierende Signalform, die durch ein zweites Filter (302) erzeugt wird, das mit dem ersten Filter (102) übereinstimmt und bei einer Mittenfrequenz schwingt, die gleich der erwünschten Mittenfrequenz ist, auf die das erste Filter (102) abgestimmt werden soll, zum Verstreichen benötigen.

## Revendications

1. Procédé de détection de la fréquence des pôles d'un filtre, comprenant :
l'excitation dudit filtre (102) par une impulsion pour amener ledit filtre (102) à osciller pour générer une forme d'onde oscillante;
le comptage d'un nombre prédéterminé d'oscillations dans ladite forme d'onde oscillante générée par ladite oscillation dudit filtre (102);
la comparaison de la période écoulée pour ledit nombre prédéterminé d'oscillations avec une période de référence connue pour générer un signal de différence correspondant à la différence entre ladite période écoulée et ladite période de référence connue; et
l'intégration dudit signal de différence pour générer un signal de commande (Vc).

2. Procédé selon la revendication 1, dans lequel l'étape de comptage comprend le comptage du nombre de croisements par zéro (208) dans ladite forme d'onde oscillante (206) et de comptages pour ledit nombre prédéterminé.

3. Procédé selon la revendication 1, dans lequel ladite étape de comptage comprend les étapes de conversion de ladite forme d'onde oscillante en une série d'impulsions (210) et le comptage numérique de ladite série d'impulsions.

4. Appareil pour détecter la fréquence des pôles d'un filtre, comprenant :
un générateur d'impulsions pour exciter ledit filtre (102) par une impulsion pour amener ledit filtre (102) à osciller afin de générer une forme d'onde oscillante (206);
un compteur (112) couplé audit filtre (102) pour compter un nombre prédéterminé d'oscillations dans ladite forme oscillante (206) générée par ladite oscillation dudit filtre (102);
un comparateur (118) couplé audit compteur (112) pour comparer la période écoulée dudit nombre prédéterminé d'oscillations à une période de référence connue afin de générer un signal de différence; et
un intégrateur (122) couplé audit comparateur (118) pour intégrer ledit signal de différence afin de générer un signal de commande (Vc).

5. Appareil selon la revendication 4, dans lequel ledit compteur (112) est un compteur numérique.

6. Appareil selon la revendication 4 ou 5, comprenant un outre un détecteur de croisement par zéro (108) pour convertir ladite forme oscillante en une série d'impulsions.

7. Procédé de syntonisation d'un filtre passe-bande, comprenant le procédé de la revendication 1, dans lequel
ladite excitation dudit filtre (102) par une impulsion amène ledit filtre (102) à osciller à sa fréquence centrale de consigne pour générer ladite forme d'onde (206);
et comprenant l'étape de syntonisation dudit filtre (102) avec ledit signal de commande (Vc).

8. Procédé selon la revendication 7, dans lequel ladite étape de comptage comprend le comptage du nombre de croisements par zéro (208) dans ladite forme d'onde oscillante (206) et de comptages pour ledit nombre prédéterminé.

9. Procédé selon la revendication 7, dans lequel ladite étape de comptage comprend les étapes de conversion de ladite forme d'onde oscillante en une série d'impulsions (210); et le comptage numérique de ladite série d'impulsions.

10. Procédé selon la revendication 7, 8 ou 9, dans lequel, dans ladite étape de comparaison, ladite période de référence connue correspond à la période écoulée pour que le même nombre d'oscillations que ledit nombre prédéterminé d'oscillations s'écoule pour une forme d'onde oscillante correspondante générée par un filtre (102) oscillant à une fréquence centrale égale à une fréquence centrale souhaitée.

11. Appareil de syntonisation d'un filtre passe-bande comprenant l'appareil de la revendication 4, dans lequel
ledit générateur d'impulsions pour exciter ledit filtre (102) par une impulsion amène ledit filtre (102) à osciller à sa fréquence centrale de consigne pour générer ladite forme d'onde oscillante (206);
et ledit signal de commande (Vc) syntonise ledit filtre (102).

12. Appareil selon la revendication 11, dans lequel ledit compteur (112) est un compteur numérique.

13. Appareil selon la revendication 11 ou 12, comprenant en outre un détecteur de croisement par zéro (108) pour convertir ladite forme d'onde oscillante en une séries d'impulsions.

14. Appareil selon la revendication 11, 12 ou 13, comprenant en outre un générateur de signal de référence (301) pour générer ladite période de référence connue correspondant à la période écoulée pour que le même nombre d'oscillations que ledit nombre prédéterminé oscillations s'écoule pour une forme d'onde oscillante correspondante générée par un second filtre (302) identique audit premier filtre (102) oscillant à une fréquence centrale égale à une fréquence centrale souhaitée à laquelle ledit premier filtre (102) doit être syntonisé.
